Europäisches Patentamt

European Patent Office

Office européen des brevets

(11) Publication number: **0 625 812 A2**

# EUROPEAN PATENT APPLICATION

(21) Application number: **94107080.7**

(22) Date of filing: **05.05.94**

(51) Int. Cl.5: **H01S 3/19**

(30) Priority: **19.05.93 JP 116782/93**

(43) Date of publication of application:
**23.11.94 Bulletin 94/47**

(84) Designated Contracting States:
**DE FR GB NL**

(71) Applicant: **MITSUBISHI DENKI KABUSHIKI KAISHA**
**2-3, Marunouchi 2-chome**
**Chiyoda-ku**
**Tokyo 100 (JP)**

(72) Inventor: **Watanabe, Hitoshi, c/o Mitsubishi Denki K.K.**
**Hikari Micro-ha Device Kenkyusho,**
**1 Mizuhara**
**4-chome, Itami-shi, Hyogo 664 (JP)**

(74) Representative: **KUHNEN, WACKER & PARTNER**
**Alois-Steinecker-Strasse 22**
**D-85354 Freising (DE)**

(54) **Quantum well type semiconductor laser device.**

(57) A quantum well type semiconductor laser includes light confining layers of MQB structure comprising a plurality of semiconductor layers having different compositions laminated alternatively, and compositions, layer thicknesses of the layers, and the laminated layer number are adjusted so as to produce an energy barrier of a height higher than the energy barrier inherent to the material against carriers injected into the active layer, and the refractive index distribution in the vicinity of the active layer makes the electric field concentrated at the active layer portion, and the quantum barrier layers are disposed in contact with the quantum well structure active layer. Therefore, the light confinement amount into the active layer is increased as well as the overflow of carriers into the light confinement layer is suppressed, whereby the threshold current of the quantum well laser is reduced, and the external quantum efficiency is enhanced. A quantum well laser includes as a barrier layer constituting an active layer of multi-quantum well structure, a barrier layer of an MQB structure that produces an energy barrier of a height higher than the energy barrier inherent to the material against the carriers injected into the well layer constituting a multi-quantum well structure. Therefore, the similar effects as above are obtained.

Fig.1

EP 0 625 812 A2

## FIELD OF THE INVENTION

The present invention relates to a quantum well type semiconductor laser used in such as optical communication and, more particularly, to a quantum well type semiconductor laser that can enhance the dynamic characteristics of a laser.

## BACKGROUND OF THE INVENTION

It is well known that semiconductor lasers have been improving their performances tremendously by introducing a quantum well structure into the active layer. The quantum well utilizes quantum size effect generated by thinning the layer thickness to about de Broglie wavelength, that is, below about 10 nm (100 Å), and when it is applied to a semiconductor laser, a single or periodic plural layers are introduced into an active layer. In such quantum well type laser, carriers are injected into the quantum well layer, and light generation and recombination occur, thereby obtaining a tremendously large optical gain with relative to the prior art bulk crystal laser. As a result, lowering of threshold, narrowing of spectrum line width, or enhancement of dynamic characteristics are realized.

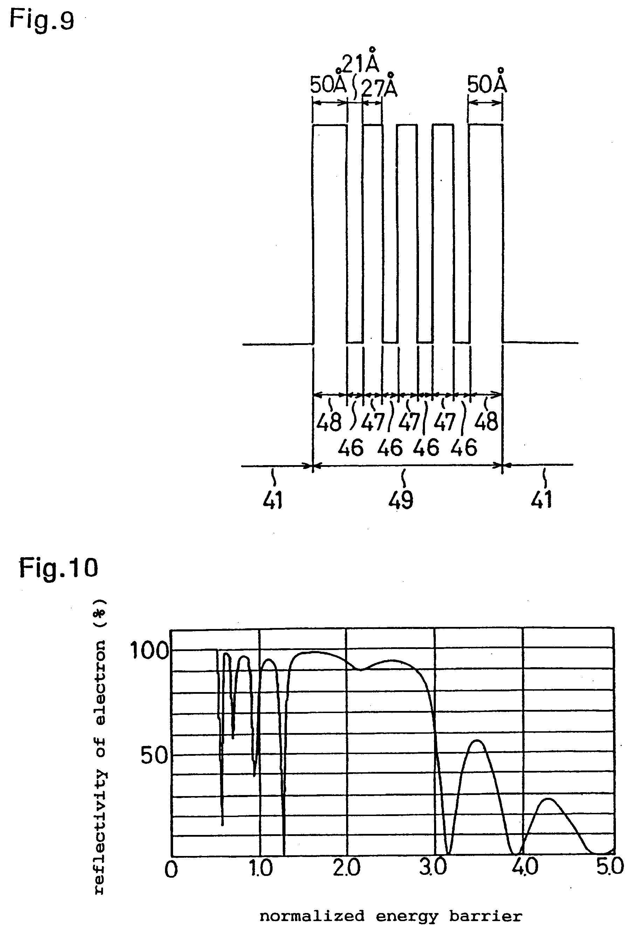

Figure 10 is a diagram showing a structure of a main part of a quantum well type semiconductor laser proposed at the beginning of development of a quantum well type semiconductor laser. In the figure, reference numeral 110 designates a p type InP substrate. A p type lower cladding layer 120 is disposed on the substrate 110. A multi-quantum well structure active layer 140 comprising a plurality of InGaAs well layers and a plurality of InP barrier layers is disposed on the lower cladding layer 120. An n type InP upper cladding layer 160 is disposed on the quantum well active layer 140. An InGaAsP contact layer 170 is disposed on the upper cladding layer 160. A p side electrode 180 is disposed on the rear surface of the substrate 110 and an n side electrode 170 is disposed on the contact layer 170, respectively.

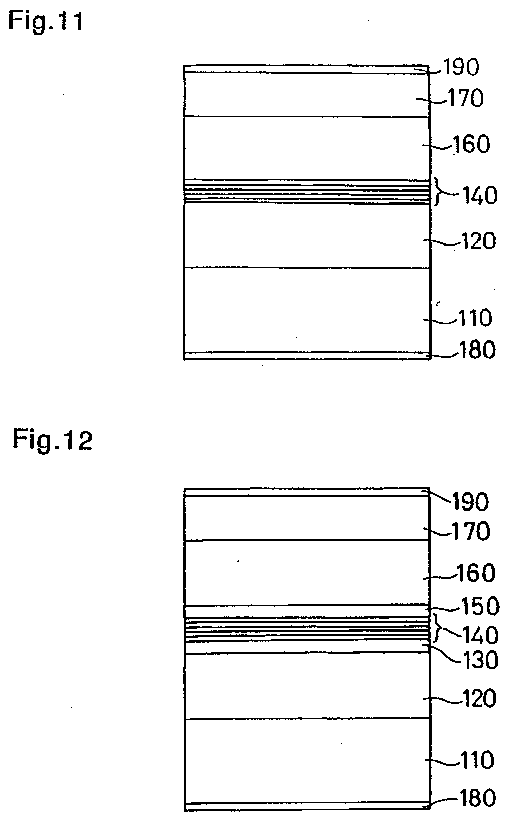

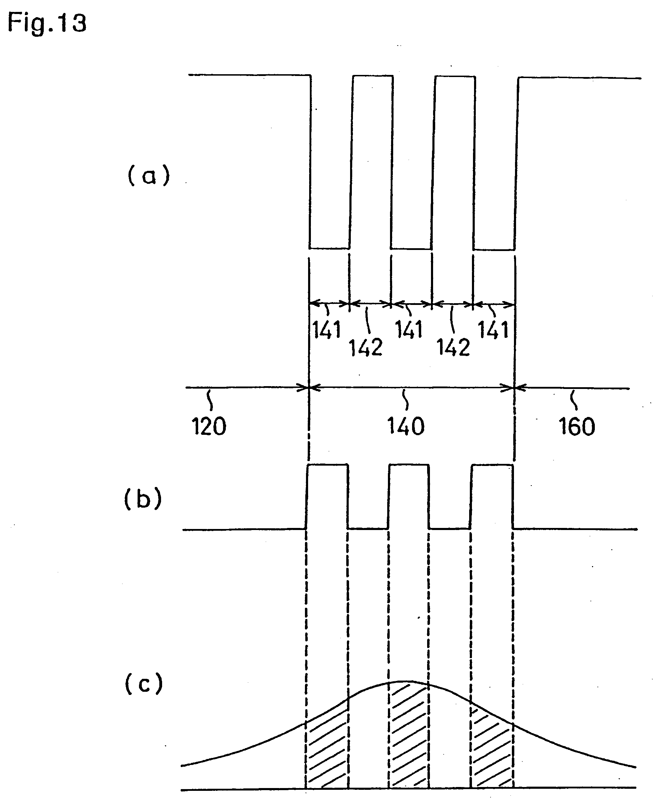

Figure 13 is a diagram for explaining the operation of the quantum well type semiconductor laser shown in figure 11, where figure 13(a) is an energy band diagram of conduction band in the vicinity of the active layer, figure 13(b) is a diagram showing refractive index corresponding to figure 13(b), and figure 13(c) is a diagram showing electric field distribution corresponding to figure 13(a). In the figures, the same reference numerals used in figure 11 designate the same or corresponding elements as those shown in figure 11. Reference numeral 141 designates an InGaAs well layer, and reference numeral 142 designates an InP barrier layer. The layer thickness of the well layer 141 is, for example, about 10 nm (100 Å), the layer thickness of the barrier layer 142 is, for example, 10 nm (100 Å), and the layer thicknesses of the lower cladding layer 120 and the upper cladding layer 160 are, for example, about 1.5 μm.

A description is given of the operation.

The electrons injected from the cladding layer 160 into the active layer 140 are recombined with positive holes in the well layer 141, thereby generating light. In the quantum well type semiconductor laser shown in figure 11, by the quantum size effect appearing by that the carriers injected into the thin well layer 141 behave as quantum dynamic wave motion, quite large optical gain per unit injection current amount is generated with relative to the semiconductor laser having a bulk crystal active layer of about 70 to 100 nm (700 to 1000 Å). On the other hand, the threshold value of a laser is represented by a product of optical gain and light confinement amount. Accordingly, in order to lower the threshold value of a laser, it is important to enhance the optical gain per unit injection current, as well as to increase the light confinement amount. In the quantum well type semiconductor laser shown in figure 11, while it is possible to increase the optical gain per unit injection current as described above, it is impossible to increase the light confinement amount as for the following reason. That is, although the vicinity of the active layer of a quantum well type semiconductor laser has a refractive index distribution as shown in figure 13-(b), because the active layer (well layer 141) is quite thin as about 5nm (50 Å), the light generated in the active layer cannot sense the difference in the refractive index between the active layer and the cladding layer. As a result, the electric field distribution becomes one broadened smoothly in the layer direction, only having a small degree of concentration into the inside of the active layer. This is a phenomenon which cannot be seen in a semiconductor laser having an active layer of bulk crystal of about 70 to 100 nm (700 to 1000 Å) thickness. Here, the light confinement amount is represented by the area of the diagonal line portion of the electric field distribution in figure 13(c), and because the electric field distribution is broadened largely in the layer thickness direction, it is impossible to increase the light confinement amount into the quantum well layer. Accordingly, in the laser structure of figure 11, it is difficult to lower the threshold current.

Figure 12 is a diagram illustrating a structure of a quantum well type semiconductor laser which is devised in order to solve the above-described problems. In the figure, the reference numerals used in figure 11 are used to designate the same or corresponding elements. A p type InGaAsP light confinement layer 130 is disposed between the lower cladding layer 120 and the quantum well active layer 140. An n type InGaAsP light confinement layer 150 is disposed between the quantum well active layer 140 and the upper cladding layer 160.

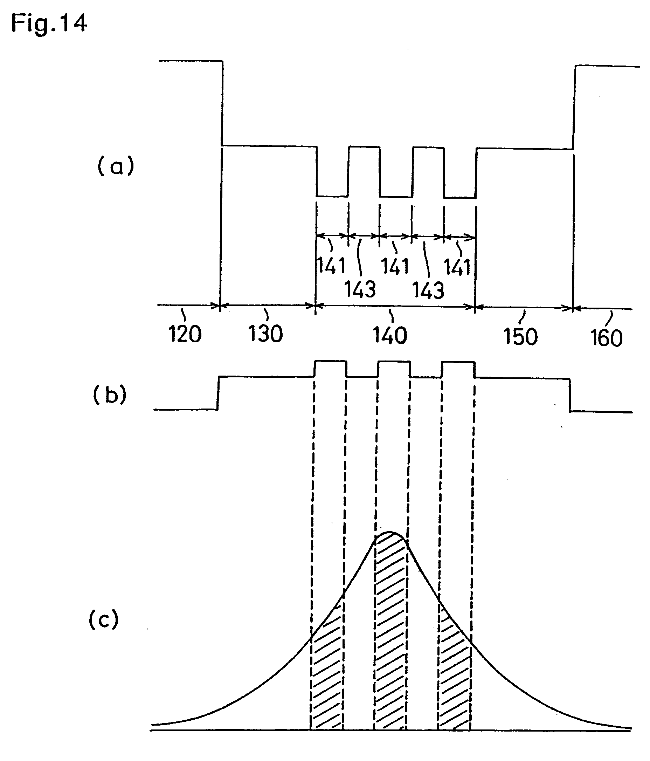

Figure 14 is a diagram for explaining the operation of the quantum well type semiconductor laser shown in figure 12, where figure 14(a) is an energy band diagram showing an energy band structure of conduction band in the vicinity of the active layer, figure 14(b) is a diagram showing the refractive index distribution corresponding to figure 14(a), and figure 14(c) is a diagram showing the electric field distribution corresponding to figure 14-(a). In the figures, the reference numerals used in figure 12 are used to designate the same or corresponding elements. Reference numeral 141 designates an InGaAs quantum well layer and reference numeral 143 designates an InGaAsP barrier layer.

A description is given of the operation.

Electrons injected into the cladding layer 160 diffuse into the light confinement layer 150 to be input to the quantum well active layer 140, and are recombined with positive holes in the well layer 141, thereby generating light. As similarly in the quantum well type semiconductor laser shown in figure 11, a large optical gain is generated by quantum size effect. In addition, the light confinement amount is represented by the area of the diagonal line portion of an electric field distribution, and it can be largely enhanced by the optimum design of the refractive index distribution. Although the electric field distribution is broadened in the layer direction in a simple structure shown in figure 11 and it is quite difficult to enhance the light confinement amount, in the laser structure of figure 12, it is possible to optimize the refractive index distribution and concentrate the electric field in the vicinity of the quantum well layer. As a result, the light confinement coefficient when the light confinement layer is introduced, amounts to about 3 to 5 times as that of the case where no light confinement layer is provided.

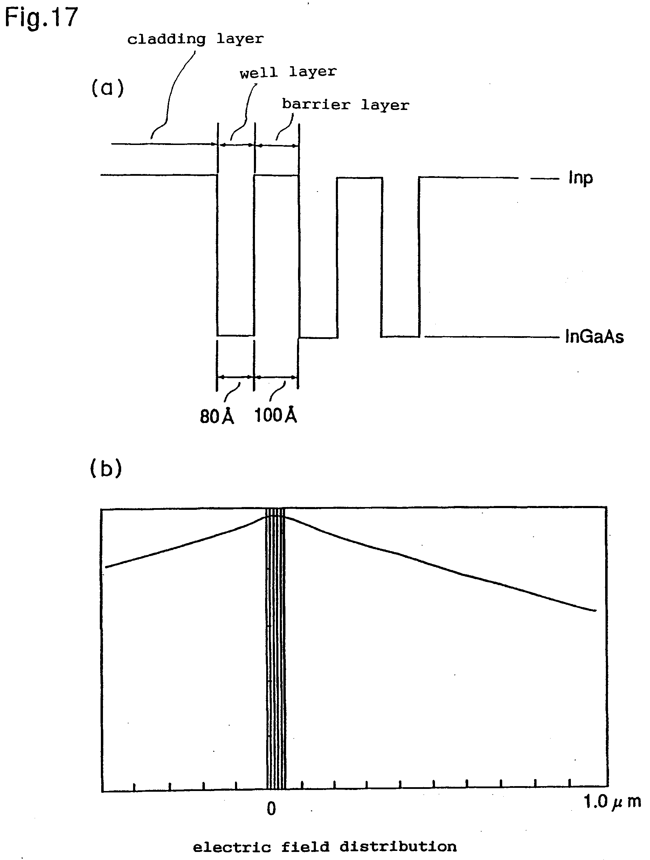

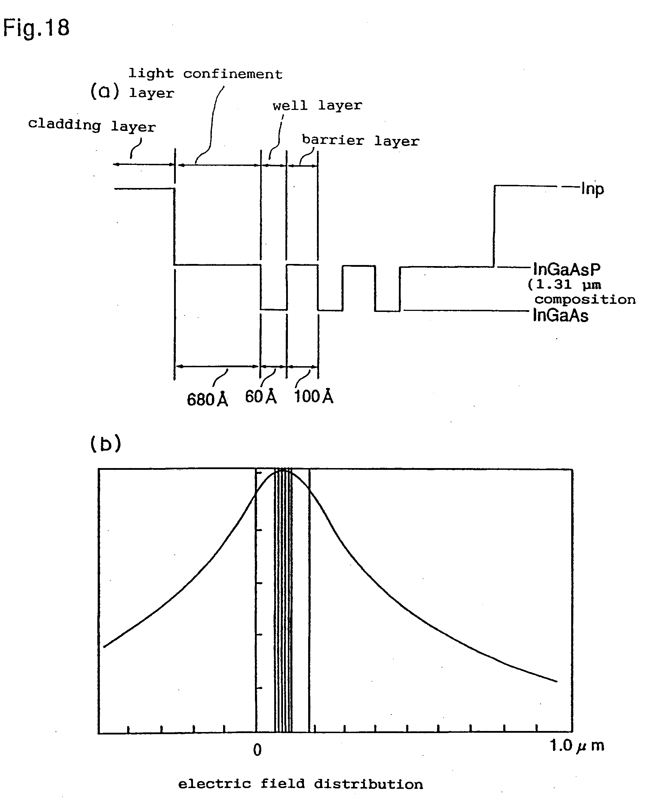

The calculation examples of the light confinement coefficient and electric field distribution in the quantum well type semiconductor laser of figures 11 and 12 will be described with reference to figure 17. In figure 11, the light confinement coefficient of confining the light into the well layer when the active layer 140 comprises three InGaAs well layers of 8 nm (80 Å) and two InP barrier layers of 10 nm (100 Å) laminated alternatively as shown in figure 17(a) is 0.5 %, and then the electric field distribution becomes one having small concentration into the active layer and of smooth configuration. On the other hand, in figure 12, the light confinement coefficient of confining the light into the well layer when the active layer 140 comprises three InGaAs well layers of 6 nm (60 Å) and two InGaAsP barrier layers of 10 nm (100 Å) corresponding to a light wavelength of 1.31 $\mu$m laminated alternatively and the light confinement layers 130 and 150 comprise InGaAsP of composition corresponding to a wavelength of 1.31 $\mu$m having 68 nm (680 Å) thickness, is 1.8 %, and this is largely enhanced with relative to a case where there is no light confinement layer. In addition, the electric field distribution then becomes one having a large degree of concentration into the active layer and of a steep configure as shown in figure 18(b).

In this way, the performance of the semiconductor laser having an active layer comprising a quantum well structure is only insufficiently enhanced by introducing a quantum well layer into the active layer, and is realized for the first time by inserting a light confinement layer.

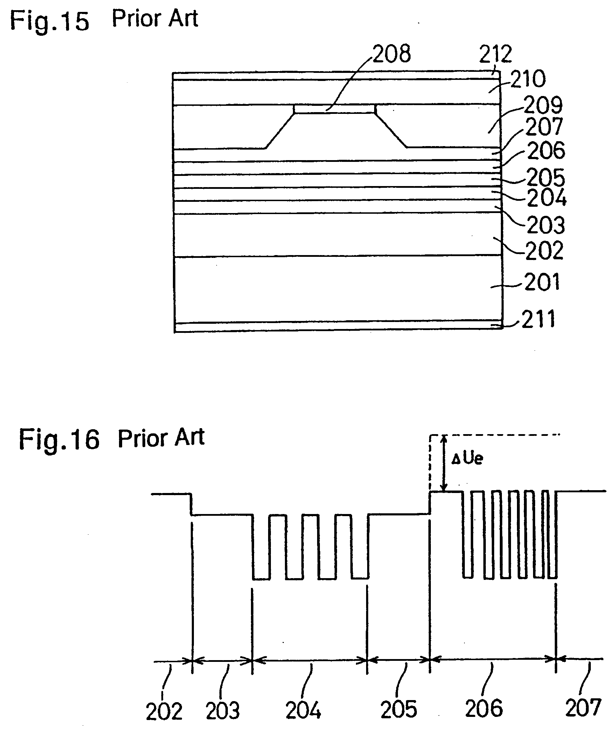

In order to lower the threshold current of a semiconductor laser, it is necessary to effectively confine the carriers to the active layer. Particularly, in the quantum well type semiconductor laser having quite a small thickness as below about 10 nm (100 Å) for the active layer, the carriers injected into the active layer flow out to the cladding layer, whereby the carriers are not effectively utilized. In order to lower the threshold current of a semiconductor laser by preventing such overflow of carriers, a structure shown in figure 15 is conventionally proposed. Figure 15 is a cross-sectional view showing a conventional quantum well type semiconductor laser comprising InGaAsP series material. In figure 15, reference numeral 15 designates an n type GaAs substrate. An n type $In_{0.5}$-$(Ga_{0.3}Al_{0.7})_{0.5}P$ cladding layer 202 is disposed on the n type GaAs substrate 201. An $In_{0.5}(Ga_{0.5}Al_{0.5})$-$_{0.5}P$ guide layer 203 is disposed on the p type cladding layer 202. A multi-quantum well active layer 204 comprising a plurality of InGaP well layers and a plurality of $In_{0.5}(Ga_{0.5}Al_{0.5})_{0.5}P$ barrier layers alternatively laminated with each other is disposed on the guide layer 203. A $In_{0.5}(Ga_{0.5}Al_{0.7})$-$_{0.5}$ guide layer 205 is disposed on the multi-quantum active layer 204. A multi-quantum barrier structure 206 comprises InGaP layers and $In_{0.5}$-$(Ga_{0.3}Al_{0.7})_{0.5}P$ layers alternatively laminated with each other and an $In_{0.5}(Ga_{0.3}Al_{0.7})_{0.5}P$ cladding layer 207 is disposed on the MQB structure 206. A p type InGaAsP cap layer 208 is disposed on the p type upper cladding layer 207. Reference numeral 209 designates a current blocking layer, reference numeral 210 designates a p type GaAs layer, reference numeral 211 designates an n side electrode, and reference numeral 212 designates a p side electrode.

Figure 16 is a diagram showing the energy band structure of conduction band of the vicinity of the active layer of the semiconductor laser shown in figure 15. In the figure 16, the same reference numerals designate the same or corresponding portions as shown in figure 15.

The MQB structure is constituted by laminating a plurality of heterojunctions produced by mutually different composition semiconductor layers of several atomic layers. The first one that has introduced an MQB structure into a semiconductor laser is proposed by Professor Iga of Tokyo Institute of Technology, for example, in Japanese Published Patent Application No.63-46788. This provides a structure in which an MQB structure layer that has laminated a plurality of GaInAsP thin films and a plurality of InP thin layers between active layer and cladding layer of bulk crystals, and whereby the flowing out of carriers from the active layer to the cladding layer in the high temperature operation of semiconductor laser is suppressed, whereby the temperature characteristics of the laser is enhanced.

On the other hand, in the quantum well type semiconductor laser, the phenomenon of carrier overflow can be seen even in the normal temperature operation, and the introduction of the MQB structure results the effect of lowering the threshold current of the laser at the normal temperature operation. In the prior art example of figure 15, six InGaAs layers of all 2 nm (20 Å) thickness and six $In_{0.5}(Ga_{0.3}Al_{0.7})_{0.5}P$ layers of 50 nm (500 Å), 6 nm (60 Å), 3 nm (30 Å), 3 nm (30 Å), 3 nm (30 Å), 3 nm (30 Å) from the side in contact with the guide layer 205 are alternatively laminated. When such short period potential barriers exist, the electron behaves as a wave motion and an interference effect also arises by performing an appropriate design, and therefore, the electrons sense an energy barrier larger than the potential barrier possessed by the actual material and are reflected. In other words, the electrons flowing out from the active layer are reflected by the MQB structure and are returned to the region of the guide layer. In the figure, the increment of the energy barrier sensed by the electron is shown as $\Delta Ue$ added to the band-discontinuity amount of the conduction band.

In this way, because the prior art quantum well type semiconductor laser shown in figure 15, has a structure in which an MQB structure is provided between the guide layer (light confinement layer) and the cladding layer, the overflow of electrons from the active layer to the cladding layer are suppressed, and the electrons are effectively confined in the active layer, whereby the threshold current of the semiconductor laser can be reduced.

As described above, the introduction of the light confinement layer is indispensable to the semiconductor laser having an active layer of quantum well structure. However, because the light confinement layer is designed to have an intermediate composition between the well layer and the cladding layer of the quantum well active layer, the potential barrier against the electrons injected to the well layer are restricted by the light confinement layer. Therefore, the electrons are likely to overflow to the barrier layer or light confinement layer of the quantum well active layer, and it causes the threshold current of the laser increase and the dynamic characteristics of the laser eminently deteriorate. This is actually pointed out by W. Rideout et al., IEEE Photon Tech Lett., vol.3 pp784-786 1991).

In the prior art quantum well type semiconductor laser shown in figure 15, the overflow of electrons into the cladding layer is suppressed, but it is not paid considerations on preventing the overflow of electrons into the barrier layer and the light confinement layer of the quantum well active layer, and there also arise the above-described problems in this prior art device.

SUMMARY OF THE INVENTION

It is an object of the present invention to provide a quantum well type semiconductor laser that can keep the light confinement amount largely and can also suppress that electrons overflow to the barrier layer or light confinement layer.

Other objects and advantages of the present invention will become apparent from the detailed description given hereinafter; it should be understood, however, that the detailed description and specific embodiment are given by way of illustration only, since various changes and modifications within the scope of the invention will become apparent to the those skilled in the art from this detailed description.

According to a first aspect of the present invention, light confining layers of multiple quantum barrier structure comprising a plurality of semiconductor layers having mutually different compositions laminated alternatively with each other are provided, and compositions and layer thicknesses of the light confining layers and laminated layer number thereof are adjusted so that those layers produce an energy barrier having a height larger than the energy barrier height inherent to the material against carriers which are injected into the active layer, and the refractive index distribution in the vicinity of the active layer becomes one which makes the electric field concentrated at the active layer portion, and the quantum barrier layers are disposed in contact with the quantum well structure active layer.

Therefore, the light confinement amount into the active layer can be increased as well as the overflow of carriers into the light confinement layer can be suppressed, whereby the threshold current of the quantum well type semiconductor laser can be reduced, and the external quantum efficiency can be enhanced.

According to a second aspect of the present invention, as a barrier layer constituting an active layer of a multi-quantum well structure, there is provided a barrier layer of a multi-quantum well barrier structure that produces an energy barrier of the height larger than that of the energy barrier inherent to the material against the carriers injected onto the well layer constituting a multi-quantum well structure.

Therefore, the overflow of carriers into the barrier layer can be suppressed, and thereby the threshold current of the quantum well type semiconductor layer is reduced, the external quantum efficiency is increased, and the dynamic characteristics can be enhanced.

BRIEF DESCRIPTION OF THE DRAWINGS

Figure 1 is a perspective view showing a structure of a quantum well type semiconductor laser according to a first embodiment of the present invention.

Figure 2 is a cross-sectional view schematically showing a main portion of a quantum well type semiconductor laser of figure 1.

Figure 3 is a diagram for explaining the operation of the quantum well type semiconductor laser of figure 1.

Figure 4 is a diagram showing reflectivity of electron against the MQB structure used in the quantum well type semiconductor laser of figure 1.

Figure 5 is a diagram for explaining the operation of a quantum well type semiconductor laser according to a second embodiment of the present invention.

Figure 6 is a cross-sectional view schematically illustrating a main portion of a quantum well type semiconductor laser according to a third embodiment of the present invention.

Figure 7 is an energy band diagram showing the conduction band of the vicinity of the barrier layer of the quantum well type semiconductor laser of figure 6.

Figure 8 is a diagram showing the reflectivity of electron against the MQB structure constituting a barrier layer of the quantum well type semiconductor laser of figure 6.

Figure 9 is an energy band diagram showing the band structure of the conduction band of the barrier layer of the quantum well type semiconductor laser according to the fourth embodiment of the present invention.

Figure 10 is a diagram showing reflectivity of electron against the MQB structure constituting a barrier layer of the quantum well type semiconductor layer according to the fourth embodiment of the present invention.

Figure 11 is a cross-sectional view showing a structure of a main portion of a quantum well type semiconductor laser at the beginning of the development.

Figure 12 is a cross-sectional view showing the structure of a main portion of the quantum well type semiconductor laser provided with a light confinement layer.

Figure 13 is a diagram for explaining the operation of the quantum well type semiconductor laser shown in figure 11.

Figure 14 is a diagram for explaining the operation of the quantum well type semiconductor laser shown in figure 12.

Figure 15 is a cross-sectional view showing a structure of a conventional quantum well type semiconductor laser provided with an MQB structure.

Figure 16 is an energy band diagram showing a structure of conduction band of the vicinity of active layer of the quantum well type semiconductor laser shown in figure 15.

Figure 17 is a diagram for explaining the calculation examples of the light confinement amount in the quantum well type semiconductor laser shown in figure 11.

Figure 18 is a diagram for explaining the calculation examples of the light confinement amount in the quantum well type semiconductor laser shown in figure 12.

Figure 19 is a diagram for explaining the calculation examples of the light confinement amount in the quantum well type semiconductor laser according to the first embodiment of the present invention.

Figure 20 is a diagram for explaining the calculation examples of the light confinement amount in the quantum well type semiconductor laser according to the second embodiment of the present invention.

DETAILED DESCRIPTION OF THE PREFERRED EMBODIMENT

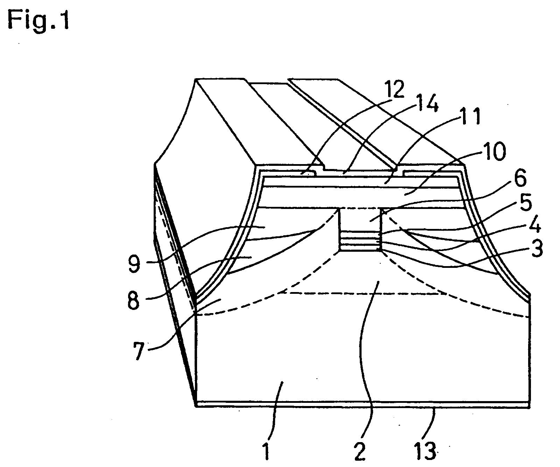

Figure 1 is a perspective view illustrating a quantum well type semiconductor laser according to a first embodiment of the present invention. In the figure, reference numeral 1 designates a p type InP substrate. A p type lower InP cladding layer 2 is disposed on the InP substrate 1. A P type light confinement layer 3 is disposed on the lower cladding layer 2, a quantum well layer 4 is disposed on the p type light confinement layer 5, and an n type InP first upper cladding layer 6 is disposed on the n type light confinement layer 5. A semiconductor laminated layer structure comprising the lower cladding layer 2 to the first upper cladding layer 6 is formed in a mesa stripe configuration by performing mesa etching reaching the substrate 1. In addition, a p type InP first burying layer 7, an n type InP second burying layer 8, and a p type InP third burying layer 9 are successively disposed so as to bury the mesa stripe. An n type InP second upper cladding layer 10 is disposed on the mesa stripe and the p type InP third burying layer 9, and an n type InGaAsP contact layer 11 is disposed on the second cladding layer 10. Reference numeral 12 designates an insulating film. An n side electrode 14 is provided on the insulating film 12, and it contacts the contact layer 11 in the stripe aperture provided in the insulating film 12. A p side electrode 13 is provided on the rear surface of the substrate 1.

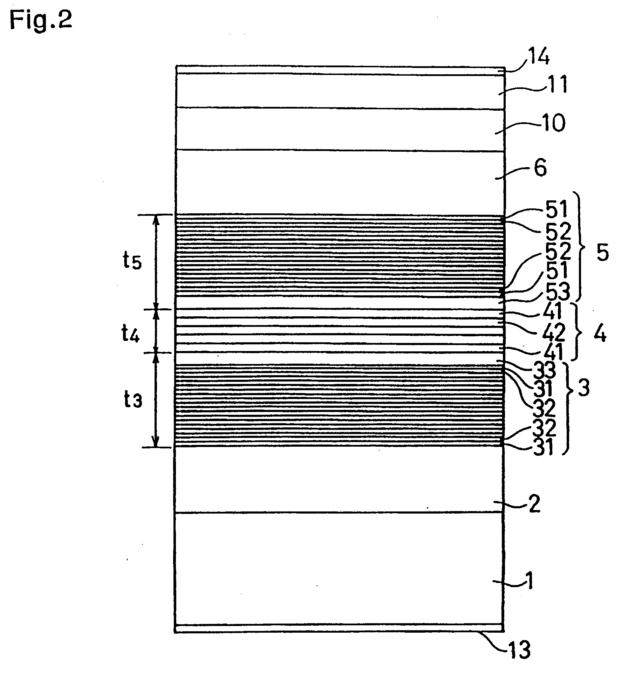

Figure 2 is a cross-sectional view schematically illustrating a main portion of the quantum well type semiconductor laser shown in figure 1. In the figure, the same reference numerals used in figure 1 are used to designate the same or corresponding elements.

The quantum well type active layer 4 comprises a multi-quantum well (hereinafter referred to as MQW) that has laminated three InGaAs well layers 41 and two InP barrier layers 42. The layer thickness of the well layer is, for example, 5 nm (50 Å), the layer thickness of the barrier layer 42 is, for example, 10 nm (100 Å), and the total thickness of the quantum well active layer 4 is 35 nm (350 Å).

The p type MQW light confinement layer 3 comprises a first barrier layer, i.e., a tunneling preventing layer 33 comprising InP disposed in contact with the quantum well active layer 4, and a superlattice structure laminating ten InGaAs well layers 31 and nine InP barrier layers 32 alternatively with each other. The tunneling preventing layer 33 is made its thickness relatively thick to be 20 nm (200 Å) in order to prevent the tunneling of electron into the superlattice structure. In the superlattice structure region, the InGaAs well layer 31 is of seven atomic layers where one atomic layer thickness is 0.3 nm (3 Å), i.e., the total thickness is 2.1 nm (21 Å), and the InP barrier layer 32 is of nine atomic layers, i.e., the total thickness is 2.7 nm (27 Å). Thus, the total thickness of the light confinement layer 3 is 65.3 nm (653 Å).

The n type MQW light confinement layer 5 comprises an InP tunneling preventing layer 53, and a superlattice structure laminating ten InGaAs well layers 51 and nine InP barrier layers 52 alternatively with each other. The layer thicknesses of the tunneling preventing layer 53, the well layer 51, and the barrier layer 52 are respectively the same as the layer thicknesses of the tunneling preventing layer 33, the well layer 31, and the barrier layer 32 constituting the p type light confinement layer 3, and the total layer thickness t5 of the n type MQB light confinement layer 5 is 65.3 nm (653 Å).

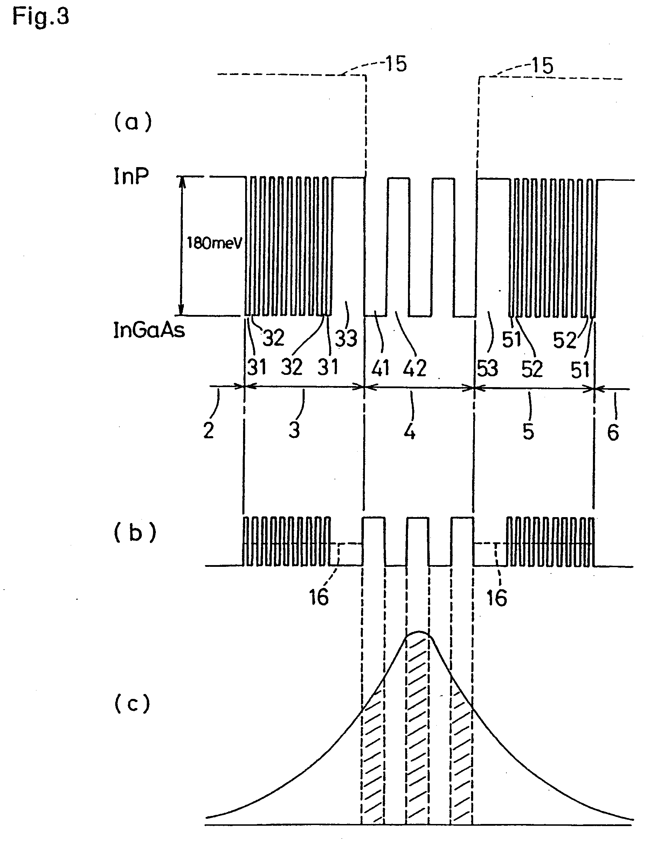

Figure 3 shows a diagram explaining the operation of the quantum well type semiconductor laser shown in figure 1, where figure 3(a) is an energy band diagram showing the band structure of conduction band in the vicinity of the active layer thereof, and figure 3(b) is a diagram showing refractive index distribution corresponding to figure 3(a), and figure 3(c) is a diagram showing the electric field distribution corresponding to figure 3-(a). In the figure, the same reference numerals used in figure 1 or 2 are used to designate the same or corresponding elements.

In the operation of the laser, electrons injected from the cladding layer 6 are recombined in the well layer 41 of the quantum well active layer, thereby generating a tremendously large optical gain. Here, electrons having a relatively high energy in the well layer 41 overflow to the outside of the well layer 41, and are intended to diffuse into the light confinement layer.

In this first embodiment, the light confinement layer is of an MQW structure as described above, and therefore, the electrons which overflow to the light confinement layer can be eminently reduced. That is, when the above-described potential barriers of short period exists, the electron behaves as wave motion, and by conducting an appropriate design, an interference effect occurs and the electron senses the energy barrier 15 larger than the potential barrier which the actual material inherently possesses, and the electron is reflected and again captured by the quantum well.

The concrete increasing effect of the potential barrier due to the MQW structure used in this embodiment will be described with reference to the calculation results.

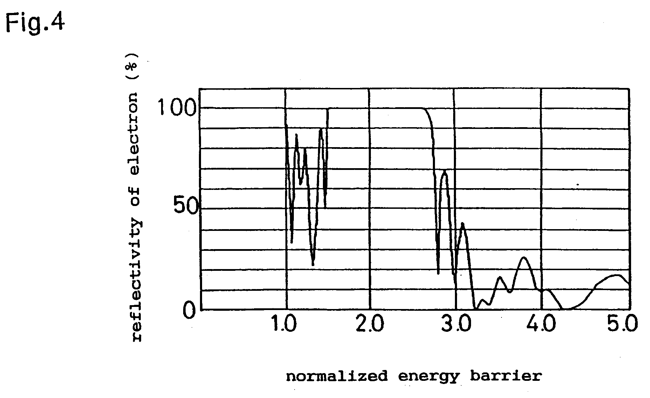

Figure 4 is a diagram showing the calculated value of energy barrier against electron in the MQB structure of this embodiment, where the ordinate takes the energy of electron normalized by the value of real energy barrier (inherent to the material) between InP and InGaAs, and the abscissa takes the reflectivity of electron against MQW. The real energy barrier between InP and InGaAs becomes about 180 meV when $\Delta Ec = 0.3$, and the value 1.0 on the ordinate corresponds to 180 meV. According to the calculation results, the energy barrier due to MQW is increased to about 2.8 times of the energy barrier inherent to the material, although there exist electrons which transmit a particular energy. This is a barrier having a sufficient energy height against the Fermi-Dirac distribution of electron at room temperature. Accordingly, the overflow of carriers injected into the quantum well active layer 4 into the light confinement layer 3 or 5 is greatly suppressed with relative to a case where a single InGaAsP light confinement layer is employed. In the above-described calculation, the effective mass ratio of electron is made 0.041 in the well layer and 0.077 in the barrier layer.

On the other hand, because the periods of the lamination of InP barrier layers and InGaAs well layers constituting the light confinement layer of the MQB structure are quite short, the light generated in the active layer senses as refractive index of the MQW light confinement layer a refractive index intermediate those of the InP barrier layer and the InGaAs well layer. In other words, the light confinement layer of this MQW structure functions similarly as the light confinement layer comprising InGaAsP against the light generated in the active layer, and makes the electric field concentrate to the active layer portion.

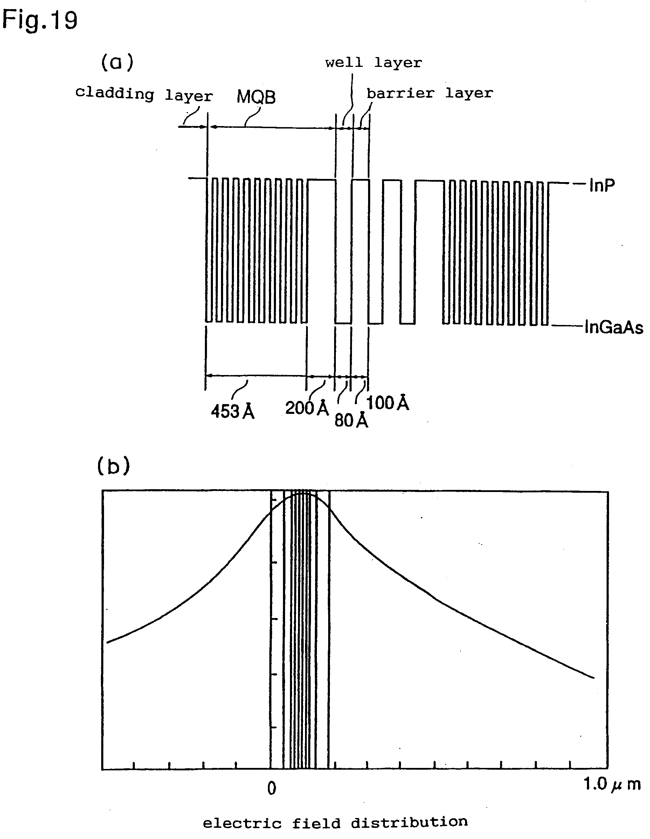

Calculation examples of the light confinement coefficient and the electric field distribution in the quantum well type semiconductor laser of this first embodiment will be described below. In figure 2, the light confinement coefficient into the well layer in a case where the active layer 4 is of a structure laminating three InGaAs well layers of 8 nm (80 Å) thickness and two InP barrier layers of 10 nm (100 Å) thickness alternatively, and the MQW light confinement layers 3 and 5 are of a structure comprising an InP tunneling preventing layer of 20 nm (200 Å) disposed in contact with the active layer 4, and a superlattice structure laminating ten InGaAs well layers of 2.1 nm (21 Å) thickness and nine InP barrier layers of 2.7 nm (27 Å) thickness alternatively, is 1.4 %, showing a large improvement with relative to a case where no light confinement layer is provided. In addition, the electric field distribution then becomes a steep configuration where the degree of concentration to the active layer is large as shown in figure 19(b).

As described above, in this first embodiment, in a quantum well type semiconductor laser, a light confinement layer of MQW structure is disposed adjacent the quantum well active layer and compositions, layer thicknesses, and the layer lamination number are designed so that an energy barrier higher than the energy barrier inherent to the material is produced against the carriers injected into the active layer and a refractive index distribution in the vicinity of the active layer becomes one concentrating the electric field to the active layer portion, and therefore, the light confinement amount into the active layer can be increased by the optimization of the refractive index distribution by introduction of the light confinement layer as well as the overflow of carriers injected into the quantum well active layer can be suppressed by the energy barrier increased by the MQW structure, and thereby the threshold current of the quantum well type semiconductor laser is reduced, the external quantum efficiency is increased, and the dynamic characteristics is enhanced.

Embodiment 2.

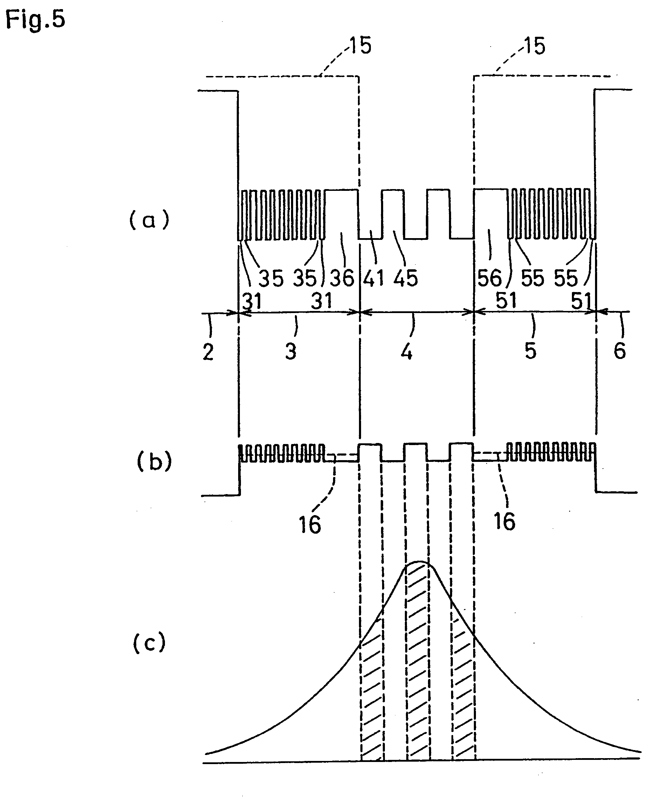

Figure 5 is a diagram for explaining a quantum well type semiconductor laser according to a second embodiment of the present invention, where figure 5(a) is an energy band diagram showing the band structure of conduction band in the vicinity of the active layer of the quantum well type semiconductor laser according to the second embodiment of the present invention, figure 5(b) is a diagram showing a refractive index distribution corresponding to figure 5(a), and figure 5(c) is a diagram showing electric field distribution corresponding to figure 5(a).

In the figure, the same reference numeral used in figure 1 or 2 are used to designate the same or corresponding elements. Reference numeral 35 designates a p type InGaAsP barrier layer, reference numeral 36 designates a p type InGaAsP tunneling preventing layer, numeral 45 designates an InGaAsP barrier layer, numeral 55 designates an n type InGaAsP barrier layer, and numeral 56 designates an n type InGaAsP tunneling preventing layer. Also in this second embodiment, similarly as in the first embodiment, the effect of increasing the energy barrier due to the MQW structure makes the energy barrier of the light confinement layer which is sensed by carriers injected into the quantum well active layer 4, the energy barrier 15 higher than the energy barrier inherent to the material between InGaAsP and InGaAs as shown in figure 5(a), and the overflow of carriers injected into the quantum well active layer 4 to the light confinement layer 3 or 5 is largely suppressed with relative to a case where a single layer InGaAsP light confinement layer is employed. Accordingly, similarly as in the first embodiment, the threshold current of the quantum well type semiconductor laser is reduced, the external quantum efficiency can be improved, and further the dynamic characteristics is enhanced.

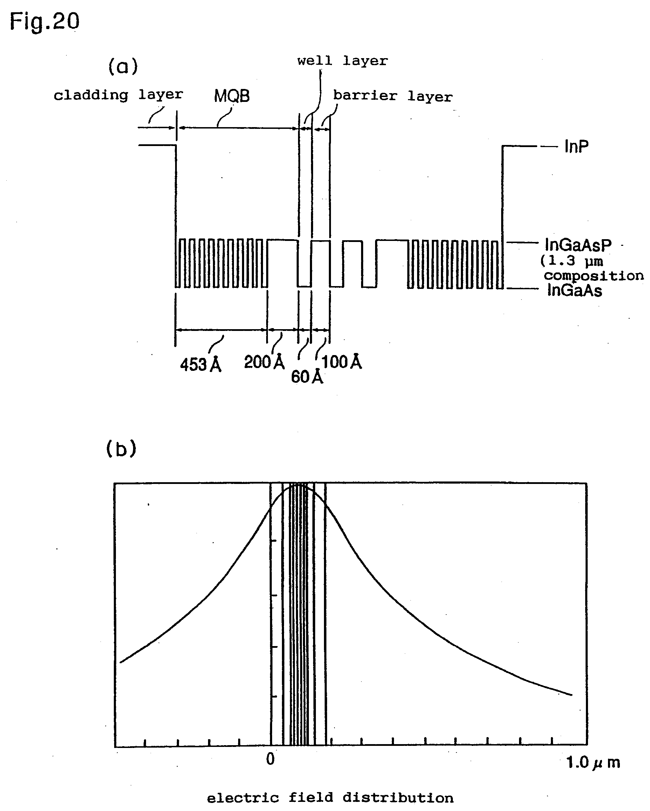

Calculation examples of the light confinement coefficient and electric field distribution in the quantum well type semiconductor laser of this embodiment will be described below. The light confinement coefficient into the well layer in a case where the active layer 4 is of a structure laminating three InGaAs well layers of 6 nm (60 Å) thickness and two InGaAsP (whose component ratio is corresponding to the wavelength of 1.3 μm) barrier layers of 10 nm (100 Å) thickness alternatively, and the MQW light confinement layers 3 and 5 are of a structure comprising an InGaAsP (whose component ratio is corresponding to the wavelength of 1.3 μm) tunneling preventing layer of 20 nm (200 Å) thickness disposed in contact with the active layer 4 and a superlattice structure laminating ten InGaAs well layers of 2.1 nm (21 Å) thickness and nine InGaAsP barrier layers of 2.7 nm (27 Å) thickness with each other, is 1.9 %, showing a large increase with relative to a case where no light confinement layer is provided. In addition, the electric field distribution then becomes a steep configuration where the degree of concentration to the active layer is large as shown in figure 20(b).

While in the above-described first and second embodiments both of the p type light confinement layer and the n type light confinement layer are of an MQW structure, the overflow phenomenon of the carriers from the active layer are particularly eminent for electrons and, therefore, only the p type light confinement layer can be made of an MQW structure, resulting an effect to some degree.

While in the above-described first and second embodiments the light confinement layers disposed at above and below of the light confinement layer are doped to p type and n type, respectively, they may be constituted by undoped semiconductor layer.

## Embodiment 3.

Figure 3 is a cross-sectional view schematically showing a quantum well type semiconductor laser according to a third embodiment of the present invention. In the figure, the same reference numerals used in figure 2 are used to designate the same or corresponding elements. The third embodiment of the present invention employs as a barrier layer constituting the quantum well active layer 4, that of an MQW structure. The MQW barrier layer 49 is constituted by an InP tunneling preventing layer 48 disposed in contact with the well layer 41 constituting the quantum well active layer 4, and a structure alternatively laminating InGaAs well layer 46 and InP barrier layer 47. Reference numeral 30 designates a p type InGaAsP light confinement layer and numeral 50 designates an n type InGaAsP light confinement layer.

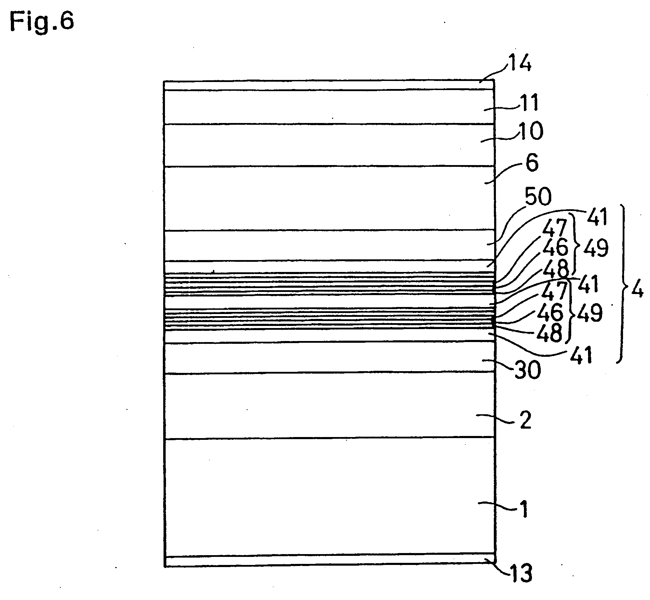

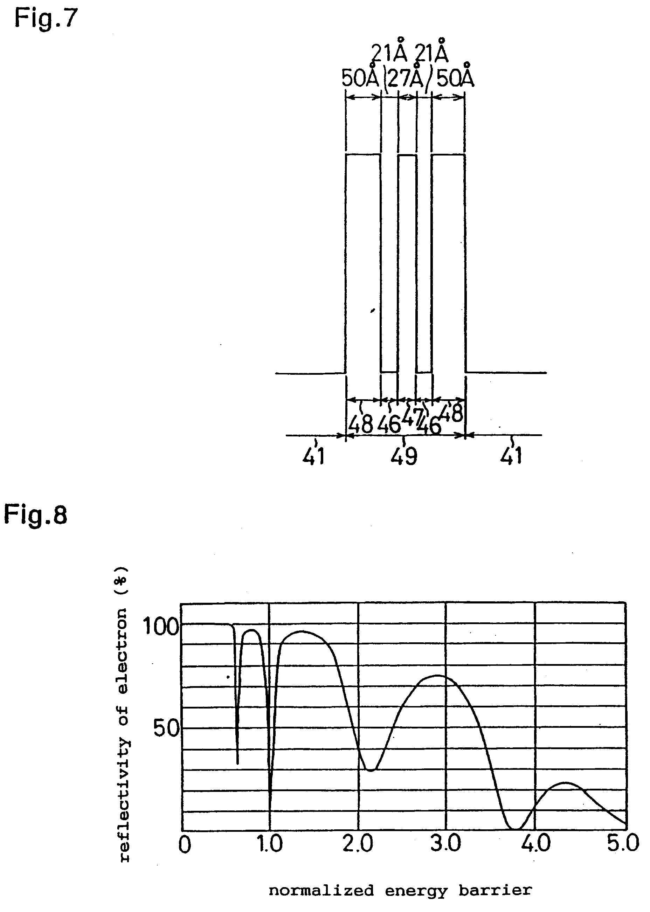

Figure 7 is an energy band diagram illustrating an energy band structure of conduction band of the vicinity of the MQW barrier layer 6, where the same reference numerals as those in figure 6 are used to designate the same or corresponding elements.

The barrier layer in the MQW structure is required to be made thick so that the overlapping of the wave functions in the adjacent well regions are sufficiently small. However, when the barrier layer is designed unlimitedly thick, the entire layer thickness of the active layer becomes too thick, and the controllability of the transverse mode of the laser light is deteriorated. Accordingly, the barrier layer is usually designed to 15 to 30 nm (150 to 300 Å). In this embodiment, tunneling preventing layers 48 of 5 nm (50 Å) thick functioning against electrons are provided at both sides, and two well layers 46 of 2.1 nm (21 Å) thickness and a barrier layer 47 of 2.7 nm (27 Å) thickness are provided inserted therebetween. The entire layer thickness of the barrier layer 49 is 16.9 nm (169 Å). Figure 8 is a diagram showing the calculation examples of the energy barrier against electrons in MQB having a structure shown in figure 7, and the ordinate takes a value which is obtained by normalizing the value of the real energy barrier between InP and InGaAsP, and the abscissa takes a value of reflectivity of electron against MQW. The value of 1.0 on the ordinate corresponds to 180 meV. As shown in the figure, in the MQW structure of figure 7, although there actually occurs transmission at a particular energy, reflectivity of larger than 70 % is obtained up to about 1.8 times of real energy barrier.

The electrons injected into the well layer 1 are recombined and generate a tremendously large optical gain. Here, the electrons having a relatively high energy in the well layer 41 overflow to the outside of the well layer 41, and are intended to diffuse to the barrier layer constituting a quantum well active layer, but these are reflected by the increased energy barrier of the MQW structure, and again captured by the quantum well. As a result, this embodiment can eminently reduce the overflow of electrons which are injected into the well layer 41 out to the barrier layer.

As described above, in this third embodiment, a multi-quantum barrier structure barrier layer 49 comprising a plurality of mutually different composition semiconductor layers laminated with each other and producing an energy barrier higher than the energy barrier inherent to the material against the carriers injected into the well layer constituting a multi-quantum well structure is provided, and therefore, the overflow of carriers into the barrier layer can be suppressed, and thereby the threshold current of the quantum well type semiconductor laser is reduced, the external quantum efficiency is increased, and the dynamic characteristics is improved.

## Embodiment 4.

Figure 4 is an energy band diagram showing the energy band structure of conduction band of the vicinity of the barrier layer of the multi-quantum well active layer of the quantum well type semiconductor laser according to a fourth embodiment of the present invention. In figure 9, the same reference numerals are used to designate the same or corresponding elements as used in figure 7. The structure other than the barrier layer 49 of the fourth embodiment are the same as those of the third embodiment.

In the above-described third embodiment two InGaAs well layers 4 are provided for the MQW barrier layer 49, but in this fourth embodiment four InGaAs well layers 46 are provided. In other words, tunneling preventing layers 48 of 5 nm (50 Å) thick functioning against electrons are provided at both sides, and four well layers 46 of 2.1 nm (21 Å) thickness and three barrier layers 47 of 2.7 nm (27 Å) thickness are laminated with each other. The entire layer thickness of the barrier layer 49 are 26.5 nm (265 Å). Figure 10 is a diagram showing calculation examples of the energy barrier functioning against electrons in the MQW having a structure shown in figure 9, and the ordinate takes a value which is obtained by normalizing the energy of electron by the value of the actual energy barrier between InP and InGaAs, and the abscissa takes reflectivity of electron against MQW. The value of 1.0 on the ordinate corresponds to 180 meV. As shown in the figure, in the MQW structure of figure 9, although there occurs transmission at a particular energy, reflectivity of about 70 % or more as up to about three times of the real energy barrier. Accordingly, in this embodiment, the overflow of the electron injected to the well layer 41 out to the barrier layer 49 are eminently reduced with relative to the third embodiment.

While in the above-described third and fourth embodiments, one in which the light confinement layer comprises a single InGaAsP layer is described, by introducing the MQW structure shown in the first and the second embodiment as a light confinement layer, the both of the overflow of electron to the barrier layer and the overflow of electron into the light confinement layer are effectively suppressed, and a further large effect is obtained in the reduction of the threshold voltage and the enhancement of the dynamic characteristics of a quantum well type laser device.

The whole structure of the quantum well type semiconductor laser and its current confinement structure are not limited to that of PPIBH (P-substrate partially inverted buried heterostructure), and other structures which can be applied to a quantum well type semiconductor laser, for example, a ridge waveguide structure may be employed.

While in the above-illustrated embodiments, a p type substrate is employed, the present invention may be applied to those of n type substrate with inverting the conductivity types of respective layers.

While in the above embodiments lasers of 1.2 to 1.6 μm wavelength band employing an InP substrate and InGaAsP series material for the active layer are employed, the present invention can be applied to a laser of 0.66 to 0.69 μm wavelength band employing a GaAs substrate and InGaAsP series material for the active layer with the same effects as described above.

As is evident from the present invention, according to a first embodiment of the present invention, in a quantum well type semiconductor laser, a light confinement layer of an MQW structure is provided, thereby the light confinement amount into the active layer is increased and the overflow of carriers to the light confinement layer is suppressed, whereby the threshold current of the quantum well type semiconductor laser is reduced, the external quantum efficiency is increased, and the dynamic characteristics is enhanced.

Furthermore, according to a second embodiment of the present invention, in a quantum well type semiconductor laser a barrier layer of MQB structure is provided as a barrier layer constituting a multi-quantum well structure is provided, thereby the overflow of carriers to the light confinement layer is suppressed, whereby the threshold current of the quantum well type semiconductor laser is reduced, the external quantum efficiency is increased, and the dynamic characteristics is enhanced.

## Claims

1. A quantum well type semiconductor laser, comprising:

    light confining layers (3,5) of multiple quantum barrier structure comprising a plurality of semiconductor layers (31, 32, 35, 51, 52, 55) having mutually different compositions laminated alternatively with each other;

    compositions, layer thicknesses, and laminated layer number of said semiconductor layers are adjusted so that those layers produce an energy barrier having a height higher than the energy barrier height inherent to the material against carriers which are injected into an active layer (4) and the refractive index distribution in the vicinity of said active layer becomes one which makes the electric field concentrated at the active layer portion; and

    said quantum barrier layers being disposed in contact with said quantum well structure active layer.

2. The quantum well type semiconductor laser of claim 1, wherein said light confinement layer of said multi-quantum barrier structure comprises a superlattice structure body and tunneling preventing layers (33, 36, 53, 56) disposed between said superlattice structure body and said active layer of said quantum well structure;

said superlattice structure body comprising a plurality of well layers (31, 51) each having a several atomic layer thickness and comprising a first kind of semiconductor, and a plurality of barrier layers (32, 35, 52, 55) each having a several atomic layer thickness and comprising a second kind of semiconductor having a larger energy band gap than that of said first kind of semiconductor alternatively laminated with each other; and

said tunneling preventing layers being for preventing carriers in said active layer from tunneling to said superlattice structure body.

3. The quantum well type semiconductor laser of claim 2, wherein said quantum well structure active layer includes a well layer (41) comprising InGaAs, and said first kind of semiconductor comprises InGaAs and said second kind of semiconductor comprises InP.

4. The quantum well type semiconductor laser of claim 2, wherein said quantum well structure active layer includes a well layer comprising InGaAs, and said first kind of semiconductor comprises InGaAs and said second kind of semiconductor comprises InGaAsP.

5. The quantum well type semiconductor laser of claim 2, wherein said active layer is of a multi-quantum well structure.

6. The quantum well type semiconductor laser of claim 5, wherein said multi-quantum well structure active layer (4) comprises a plurality of InGaAs well layers (41) and a plurality of InP barrier layers (42) laminated with each other alternatively, and said first kind of semiconductor comprises InGaAs and said second kind of semiconductor comprises InP.

7. The quantum well type semiconductor laser of claim 6, wherein said quantum well structure active layer includes three well layers each having a layer thickness of 8 nm (80 Å) and two barrier layers each having a layer thickness of 10 nm (100 Å) laminated alternatively with each other.

8. The quantum well type semiconductor laser of claim 7, wherein said tunneling preventing layer comprised InP and has a layer thickness of 20 nm (200 Å), and said superlattice structure body includes ten well layers each having a layer thickness of 2.1 nm (21 Å) and nine barrier layers each having a layer thickness of 2.7 nm (27 Å) laminated alternatively with each other.

9. The quantum well type semiconductor laser of claim 5, wherein said multi-quantum well structure active layer (4) comprises a plurality of InGaAs well layers (41) and a plurality of InGaAsP barrier layers (45) laminated with each other alternatively, and said first kind of semiconductor comprises InGaAs and said second kind of semiconductor comprises InGaAsP.

10. The quantum well type semiconductor laser of claim 9, wherein said quantum well structure active layer includes three well layers each having a layer thickness of 6 nm (60 Å) and two barrier layers each having a layer thickness of 10 nm (100 Å) laminated alternatively with each other.

11. The quantum well type semiconductor laser of claim 10, wherein said tunneling preventing layer comprises InP and has a layer thickness of 20 nm (200 Å), and said superlattice structure body includes ten well layers each having a layer thickness of 2.1 nm (21 Å) and nine barrier layers each having a layer thickness of 2.7 nm (27 Å) laminated alternatively with each other.

12. A quantum well type semiconductor laser having a multi-quantum well structure active layer (4) comprising a plurality of well layers (41) and barrier layers (49) disposed between said well layers, comprising:

said barrier layer comprising a plurality of semiconductor layers (46, 47, 48) having mutually different compositions laminated with each other alternatively and being of a multi-quantum well structure producing an energy barrier of a height higher than that of the energy barrier inherent to the material against carriers injected into the well layer.

13. The quantum well type semiconductor laser of claim 12, wherein said multi-quantum barrier structure barrier layer comprises a superlattice structure body and tunneling preventing layers (48) disposed between said superlattice structure body and said well layer;

said superlattice structure body comprising a plurality of well layers (46) each having a several atomic layer thickness and comprising a first kind of semiconductor, and a plurality of barrier layers (47) each having a several atomic layer thickness and comprising a second kind of semiconductor having a larger energy band gap than that of said first kind of semiconductor alternatively laminated with each other; and

said tunneling preventing layers being for preventing carriers in said well layer from tunneling to said superlattice structure body.

14. The quantum well type semiconductor laser of claim 13, wherein said well layer (41) of said quantum well structure active layer comprises InGaAs, and said first kind of semiconductor comprises InGaAs and said second kind of semiconductor comprises InP.

15. The quantum well type semiconductor laser of claim 14, wherein said tunneling preventing layer (48) comprised InP and has a layer thickness of 5 nm (50 Å), and said superlattice structure body includes two well layers (46) each having a layer thickness of 2.1 nm (21 Å) and a barrier layer (47) having a layer thickness of 2.7 nm (27 Å) laminated alternatively with each other.

16. The quantum well type semiconductor laser of claim 14, wherein said tunneling preventing layer (48) comprises InP and has a layer thickness of 5 nm (50 Å), and said superlattice structure body includes four well layers (46) each having a layer thickness of 2.1 nm (21 Å) and three barrier layers (47) each having a layer thickness of 2.7 nm (27 Å) laminated alternatively with each other.

Fig.1

Fig.2

Fig.3

Fig.4

# Fig.5

Fig.6

EP 0 625 812 A2

Fig.7

21Å 21Å
50Å 27Å 50Å

48 46 47 46 48

41 49 41

Fig.8

reflectivity of electron (%)

100

50

0    1.0    2.0    3.0    4.0    5.0

normalized energy barrier

18

## Fig.9

## Fig.10

normalized energy barrier

**Fig.11**

**Fig.12**

20

Fig.13

(a)

141 141 141
142 142

120 140 160

(b)

(c)

# Fig.14

(a)

141   141   141
143   143

120   130   140   150   160

(b)

(c)

Fig.15  Prior Art

Fig.16  Prior Art

Fig.17

(a)

cladding layer

well layer

barrier layer

Inp

InGaAs

80Å    100Å

(b)

0                                              1.0 μm

electric field distribution

Fig.18

(a)

cladding layer

light confinement
layer

well layer

barrier layer

Inp

InGaAsP
(1.31 µm
composition

InGaAs

680Å  60Å  100Å

(b)

0                                    1.0 µm

electric field distribution

## Fig.19

(a)

(b)

electric field distribution

## Fig.20

(a)

(b)

electric field distribution